# FASCICULE DE BREVET EUROPEEN

(11) **EP 0 323 936 B1**
(45) Date de publication et mention de la délivrance du brevet: **24.03.1993**
(21) Numéro de dépôt: 89420002.1
(22) Date de dépôt: 02.01.1989
(51) Int. Cl.: H01L 21/82, H01L 29/78

(54) **Procédé de fabrication d'un circuit intégré comprenant des éléments à deux niveaux de grille**
Verfahren zur Herstellung einer integrierten Schaltung mit Bauelementen, die Gates auf zwei Ebenen enthalten
Process for producing an integrated circuit comprising two-level gate devices

(30) Priorité: 04.01.1988 FR 8800167
(43) Date de publication de la demande: 12.07.1989
(73) Titulaire: SGS-THOMSON MICROELECTRONICS S.A., 94250 Gentilly (FR)
(72) Inventeur: Boivin, Philippe, F-13770 Venelles (FR)
(74) Mandataire: de Beaumont, Michel

(56) Documents cités:
- EP-A- 0 200 364
- EP-A- 0 209 794
- EP-A- 0 233 823
- IBM TECHNICAL DISCLOSURE BULLETIN, vol. 21, no. 8, janvier 1979, pages 3273-3274, IBM Corp., New York, US; D.L. BERGERON et al.: "Aluminum gate self-aligned FET"

## Description

La présente invention concerne un procédé de fabrication de circuits intégrés comprenant d'une part des transistors MOS à grille isolée à un seul niveau de grille et d'autre part des dispositifs à au moins deux niveaux de grille dans et sur un même substrat semiconducteur.

Les figures 1A à 1F représentent des étapes classiques de fabrication d'un circuit intégré comprenant, d'une part, dans la partie gauche de la figure un transistor MOS, d'autre part, dans la partie droite de la figure un dispositif à deux niveaux de grille, par exemple une mémoire. La fabrication d'un circuit intégré similaire est décrite dans le document EP-A-0200364.

La figure 1A représente une étape initiale du procédé, dans laquelle, sur un substrat semiconducteur 1, par exemple un substrat de silicium, on a formé, d'une part, une couche d'oxyde de silicium mince (ci-après simplement appelé par souci de brièveté oxyde) 2, d'autre part, une couche d'oxyde épais 3 destinée à séparer entre eux deux dispositifs.

A l'étape représentée en figure 1B, on a formé au dessus de la structure une première couche de silicium polycristallin 4, une deuxième couche d'oxyde mince (ou autre isolant électrique) 5, une deuxième couche de silicium polycristallin 6 recouverte d'un masque de résine 7, la structure étant représentée après photolithogravure du masque de résine 7 et de la seconde couche de silicium polycristallin 6 pour découper la grille supérieure du dispositif de type mémoire et la grille du transistor à effet de champ.

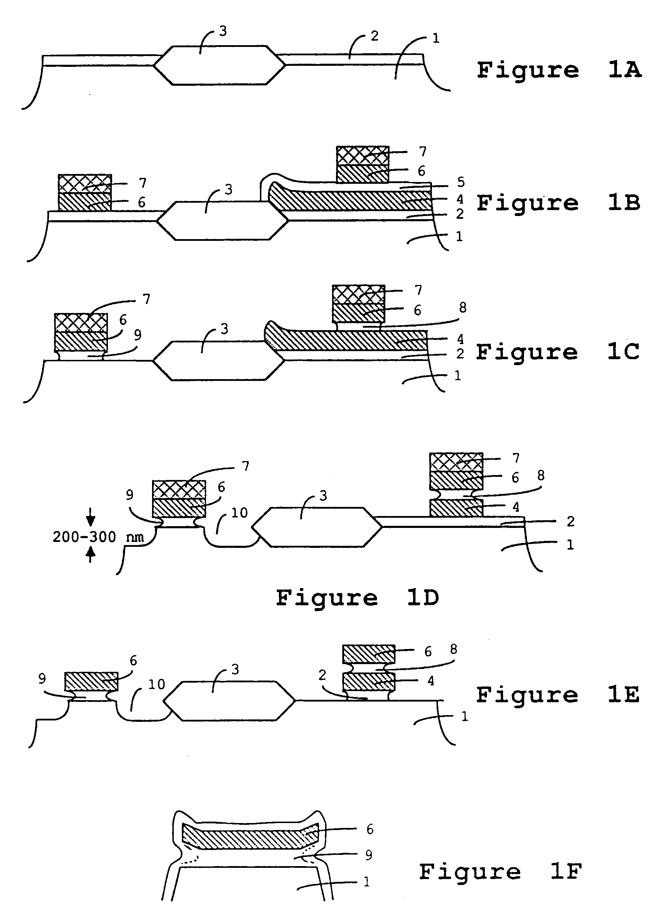

A l'étape illustrée en figure 1C, on utilise comme masque les découpes préalablement formées pour graver la couche d'oxyde 5 et conserver une portion de couche d'oxyde 8 entre les deux grilles du dispositif de type mémoire et une portion de couche d'oxyde 9 sous la grille du transistor MOS. On notera d'ailleurs que la couche d'oxyde 9 restante sur le transistor MOS peut résulter d'une partie de la couche 2 formée à l'étape de la figure 1A ou d'une partie de la couche 5 formée lors de l'étape de la figure 1B selon que la partie dans laquelle on forme le transistor MOS a été masquée ou non lors de l'une ou l'autre de ces étapes d'oxydation.

A l'étape de la figure 1D, on a représenté la gravure de premier niveau de silicium polycristallin 4 en utilisant comme masque les gravures précédemment effectuées. On notera que lors de cette gravure on grave, d'une part, comme on le souhaite, le silicium polycristallin 4 et, d'autre part, le substrat de silicium apparent au niveau du transistor MOS pour former des évidements 10 dans ce substrat de part et d'autre de la zone de grille de ce transistor MOS.

Ensuite, comme le représente la figure 1E, on grave la couche d'oxyde 2. On notera que, lors de cette gravure, on surgrave les couches de silice 8 et 9 précédemment gravées sous les zones de silicium polycristallin 6. A la figure 1E, on n'a plus représenté la couche de résine supérieure 7 qui aurait d'ailleurs dans certains technologies pu être enlevée lors de l'étape de la figure 1D.

Après l'étape de la figure 1E, on procédera généralement à des étapes de dopage, couramment par implantation ionique, pour former les zones de source et de drain des dispositifs. On procédera également, avant ou après cette étape, à une étape d'oxydation thermique pour isoler latéralement les grilles.

La figure 1F représente en vue agrandie, quoique toujours schématique, la zone de grille du transistor MOS après une réoxydation. Du fait de la présence des surgravures dans la couche d'oxyde 9, lors de la réoxydation, il se produira une dilatation de la couche d'oxyde et un relèvement des bords de la grille. La même chose se produit pour la couche de grille supérieure 6 du dispositif de type mémoire. Ce relèvement de la zone de grille présente un inconvénient tout particulier quand il s'agit d'un transistor MOS car alors les tensions de seuil sont mal contrôlées du fait que l'on applique des potentiels mal déterminés aux limites de la zone de canal du transistor. L'inconvénient est plus faible au niveau de la grille supérieure du dispositif de type mémoire puisqu'il se produit entre cette grille et la grille sous-jacente des phénomènes de transfert non spécifiquement liés aux champs latéraux.

Un autre inconvénient du procédé de la figure 1E, réside dans le fait que, lors du dopage du drain et de la source du transistor MOS, du fait du creusement 10 dans les zones de drain et de source, le profil de dopage résultant sera mal contrôlé aux limites de la zone de canal.

Ainsi, un objet de la présente invention est de prévoir un procédé de fabrication de circuit intégré comprenant simultanément des transistors MOS et des dispositifs à plusieurs niveaux de grille évitant les inconvénients de l'art antérieur tels qu'exposés précédemment.

Pour atteindre ces objets, la présente invention prévoit un procédé de fabrication de circuits intégrés comprenant des transistors MOS à grille isolée et des dispositifs à plusieurs niveaux de grille sur un substrat semiconducteur, comprenant les étapes consistant à séparer les zones dans lesquelles seront formés les divers composants par des régions d'isolement ;
déposer sur les zones où seront formés les dispositifs à plusieurs niveaux de grille au moins une première couche isolante et au moins une première couche de matériau convenant pour former une électrode de grille ;
déposer sur les zones des transistors et les zones des dispositifs à plusieurs niveaux de grille une deuxième couche isolante, une deuxième couche dudit matériau convenant pour former une électrode de grille et une première couche de produit photosensible ladite deuxième couche de materiau constituant le deuxième niveau de grille pour les dispositifs à plusieurs niveaux de grille ainsi que le seul niveau de grille des transistors ;
graver la première couche de produit photosensible et la deuxième couche de matériau selon des configurations choisies dans les zones de transistors et les zones des dispositifs à plusieurs niveaux de grille ;
revêtir les zones de transistors d'une deuxième couche de produit photosensible ;
graver sélectivement la deuxième couche de produit photosensible au centre des emplacements où doivent être formés les drains et les sources des transistors ;
attaquer les couches isolantes apparentes puis les zones de la deuxième couche de matériau et de substrat apparentes ;
éliminer la deuxième couche de produit photosensible ;
et procéder à une implantation ionique de drains et de sources en une seule étape, éventuellement précédée d'une étape thermique.

Il découle de ce procédé l'avantage que l'on n'a plus le phénomène de soulèvement de grille présenté précédemment plus particulièrement en relation avec la figure 1F et, en outre, comme on le verra ci-après, que l'on obtient en une seule étape d'implantation un profil particulièrement intéressant pour les zones de grille et de drain, ce profil étant généralement désigné dans la technique par le sigle LDD, pour indiquer que l'on a une zone de dopage moins profonde aux limites du canal et plus profonde et plus dopée aux emplacements où l'on établira les contacts de drain et de source.

Un autre avantage de ce procédé est que, lors de l'étape de dopage, on limite la profondeur de diffusion aux frontières des zones d'oxyde de champ ce qui permet d'obtenir des transistors MOS fonctionnant à plus haute tension.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1A à 1F décrivent des étapes successives de fabrication d'un circuit intégré selon l'art antérieur; et
les figures 2A à 2C représente des étapes successives de fabrication d'un circuit intégré selon la présente invention.

Dans ces diverses figures, de mêmes références désignent de mêmes couches ou portions de couche. En outre, comme cela est classique dans la représentation des circuits intégrés, les diverses épaisseurs et dimensions latérales des couches ne sont pas représentées à l'échelle ni à l'intérieure d'une figure ni d'une figure à l'autre mais ont été représentées arbitrairement dans un but de meilleure lisibilité des figures.

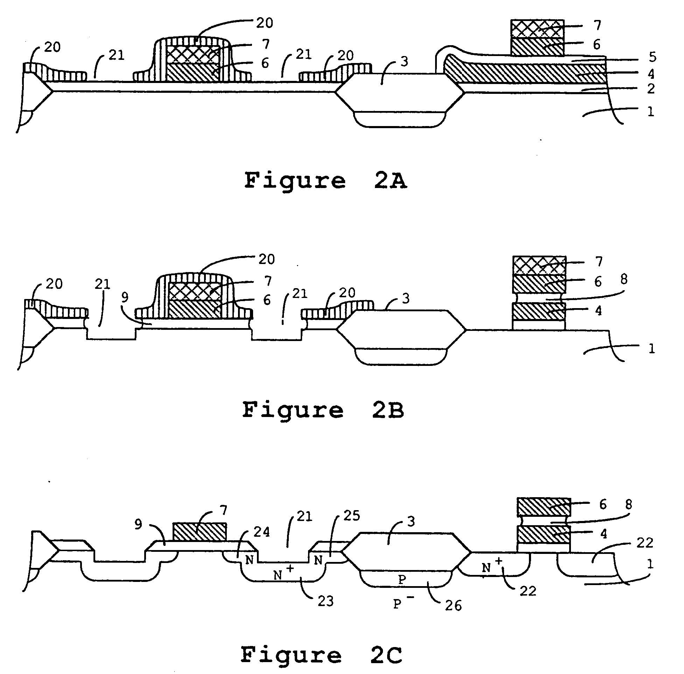

La figure 2A représente une première étape du procédé selon la présente invention qui se différencie des étapes du procédé selon l'art antérieur illustrées dans les figures 1A à 1F. Plus particulièrement, la figure 2A représente la structure telle qu'elle était à l'étape de l'art antérieur illustrée en figure 1B avec ajout d'une couche de résine 20 au dessus des zones correspondant à des transistors MOS à une seule grille.

Cette couche de résine 20, en même temps qu'elle est gravée pour être limitée à la surface supérieure des zones correspondant aux transistors MOS, est ouverte dans des régions 21 qui correspondent aux parties centrales des zones où seront formés les drains et sources des transistors MOS, Ainsi, il reste, comme le montre la figure 2A de la résine en débordement par rapport au bord des zones d'oxyde de champ 3 et en débordement par rapport à la zone de grille 6 des transistors MOS. Pour rendre sélectivement attaquable la couche de résine photosensible 20, on pourra choisir une résine différente de la résine 7 utilisée de la façon décrite précédemment en relation avec la figure 1B, ou bien, on pourra choisir une même résine en prenant soin de soumettre au préalable la résine 7 à un traitement durcissant, par exemple en présence d'ultraviolets.

On procède ensuite aux mêmes étapes que celles illustrées en relation avec les figures 1D et 1E mais, cette fois ci, comme le représente la figure 2B, seules les zones centrales des régions de drain et de source des transistors MOS seront creusées aux emplacements 21 et le creusement latéral de la couche d'oxyde de grille 9 ne se produira pas à la limite de la zone de canal mais en deçà de cette limite.

Selon un autre avantage de la présente invention, comme le représente la figure 2C, si l'on procède ensuite à une étape d'implantation ionique de formation des drains et des sources, par exemple à une implantation propre à fournir un dopage de type N⁺ dans un substrat P⁻, on obtiendra des zones implantées 22 de part et d'autre de la double grille du dispositif à plusieurs niveaux de grille, par exemple une mémoire, et une implantation dans les zones de source et de drain des transistors MOS que l'on peut différencier en deux parties, une partie plus profonde 23 sous les régions 21 liée au fait que l'on implante directement dans le silicium et une partie moins profonde et moins fortement dopée 24 aux limites de la zone de canal du fait que l'implantation se produit à travers le débordement de la couche d'oxyde de grille 9 et a été "filtrée" par cette couche d'oxyde 9. Ce même effet de filtrage se produit dans les zones 25 situées au voisinage des couches d'oxyde de champ 3.

On a également représenté en figure 2C une zone implantée de type P 26, sous la couche d'oxyde de champ 3 couramment appelée zone d'implantation de champ et destinée à favoriser l'isolement entre composants adjacents. On voit que, grâce au procédé selon la prévente invention, la couche 25 est moins profonde dans la zone où elle est voisine de la couche d'implantation de champ 26. Cette augmentation de la distance entre l'implantation de drain ou de source et l'implantation de champ favorise la tenue en tension des transistors MOS obtenus.

Quant à la structure des zones dopées de source et de drain au voisinage de la zone de grille, elle correspond à ce qui est classiquement appelé, comme cela a été mentionné précédemment, structure LDD.

La présente invention est susceptible de nombreuses variantes qui apparaîtront à l'homme de l'art. Ainsi, la protection par la couche 20 du transistor à grille unique pourrait être réalisée seulement partiellement, par exemple seulement du coté source ou du coté drain. D'autre part, alors que l'on a essentiellement décrit comme dispositif à plusieurs niveaux de grille une mémoire à deux niveaux de grille, l'invention peut s'appliquer à tout autre dispositif à plusieurs niveaux de grille combiné à des transistors MOS à grille unique.

## Revendications

1. Procédé de fabrication de circuits intégrés comprenant des transistors MOS à grille isolée et des dispositifs à plusieurs niveaux de grille sur un substrat semiconducteur, comprenant les étapes suivantes :
séparer les zones dans lesquelles seront formés les divers composants par des régions d'isolement (3) ;
former sur les zones où seront formés les dispositifs à plusieurs niveaux de grille au moins une première couche isolante (2) et au moins une première couche de matériau convenant pour constituer une électrode de grille (4) ;
former sur les zones des transistors et les zones des dispositifs à plusieurs niveaux de grille une deuxième couche isolante (5), une deuxième couche de matériau convenant pour constituer une électrode de grille (6) et une première couche de produit photosensible (7) ladite deuxième couche de matériau (6) constituant le deuxième niveau de grille pour les dispositifs à plusieurs niveaux de grille ainsi que le seul niveau de grille des transistors ;
graver la première couche de produit photosensible et la deuxième couche de matériau (6) selon des configurations choisies dans les zones de transistors et les zones des dispositifs à plusieurs niveaux de grille ;
caractérisé en ce qu'il comprend en outre les étapes suivantes :
revêtir les zones de transistors d'une deuxième couche de produit photosensible (20) ;
graver sélectivement la deuxième couche de produit photosensible au centre des emplacements où doivent être formés les drains et les sources des transistors ;
attaquer les couches isolantes (2,5) apparentes puis les zones de la deuxième couche de matériau (4) et de substrat apparentes ;
éliminer la deuxième couche de produit photosensible ;
et
procéder à une implantation ionique de drains et de sources en une seule étape.

2. Procédé selon la revendication 1, dans lequel le substrat semiconducteur (1) est un substrat de silicium monocristallin.

3. Procédé selon la revendication 2, caractérisé en ce que ledit matériau convenant pour constituer une électrode de grille est du silicium polycristallin.

## Patentansprüche

1. Verfahren zur Herstellung integrierter Schaltkreise, die MOS-Transistoren mit isoliertem Gate und Vorrichtungen mit mehreren Gate-Niveaus auf einem Halbleitersubstrat enthalten, welches die folgenden Schritte umfaßt:
- Trennen der Bereiche, in denen die verschiedenen Bestandteile gebildet werden sollen, durch Isolierabschnitte (3),
- Aufbringen von mindestens einer ersten Isolierschicht (2) und mindestens einer ersten Schicht aus einem für die Bildung einer Gate-Elektrode geeigneten Material (4) auf die Bereiche, wo die Vorrichtungen mit mehreren Gate-Niveaus gebildet werden sollen,
- Aufbringen einer zweiten Isolierschicht (5), einer zweiten Schicht des besagten, für die Bildung einer Gate-Elektrode geeigneten Materials (6) und einer ersten Schicht aus einem lichtempfindlichen Produkt (7) auf die Transistorbereiche und die Bereiche der Vorrichtungen mit mehreren Gate-Niveaus, wobei die zweite Materialschicht (6) das zweite Gate-Niveau für die Vorrichtungen mit mehreren Gate-Niveaus ebenso wie das einzige Gate-Niveau der Transistoren bildet,
- Ätzen der ersten Schicht aus einem lichtempfindlichen Produkt und der zweiten Materialschicht (6) entsprechend zu vorgewählten Konfigurationen in den Transistorbereichen und den Bereichen der Vorrichtungen mit mehreren Gate-Niveaus,
dadurch **gekennzeichnet**, daß es außerdem die folgenden Schritte umfaßt:
- Überziehen der Transistorbereiche mit einer zweiten Schicht aus einem lichtempfindlichen Produkt (20),
- selektives Ätzen der zweiten Schicht aus einem lichtempfindlichen Produkt in der Mitte der Stellen, in denen die Drains und Sources der Transistoren gebildet werden sollen,
- Angreifen der offenliegenden Isolierschichten (2, 5), dann der offenliegenden Bereiche der zweiten Materialschicht (4) und des Substrats,
- Entfernen der zweiten Schicht aus einem lichtempfindlichen Produkt und
- Vornehmen einer Ionenimplantation von Drains und Sources in einem einzigen Schritt.

2. Verfahren nach Anspruch 1, bei welchem das Halbleitersubstrat (1) ein Substrat aus monokristallinem Silicium ist.

3. Verfahren nach Anspruch 2, dadurch **gekennzeichnet**, daß das besagte, für die Bildung einer Gate-Elektrode geeignete Material aus polikristallinem Silicium besteht.

## Claims

1. A process for manufacturing integrated circuits comprising insulated gate MOS transistors and multi-gate devices on a semiconductor substrate, comprising the following steps:
- separating the areas wherein the various components are to be formed by means of insulating regions (3),
- forming on the areas where the multi-gate devices are to be formed at least a first insulating layer (2) and at least a first layer of a material suitable for constituting a gate electrode (4);
- forming on the transistor areas and the multi-gate device areas a second insulating layer (5), a second layer of a material suitable for constituting a gate electrode (6) and a first photoresist layer (7), said second layer of material (6) constituting the second gate level for the multi-gate devices and the single gate level of the transistors;
- etching the first photoresist layer and the second gate level according to chosen patterns in the transistor areas and the areas of the multi-gate devices; characterized in that it further comprises:
- coating the transistor areas with a second photoresist layer (20);
- selectively etching the second photoresist layer at the center of the places where the drains and sources of the transistors are to be formed;
- etching the apparent insulating areas (2, 5) and then the apparent areas of said second layer of material (6) and said substrate;
- removing the second photoresist layer; and
- carrying out an ionic implantation of the drains and sources in one single step.

2. A process according to claim 1, wherein the semiconductor substrate (1) is a monocrystalline silicon substrate.

3. A process according to claim 2, wherein said material suitable for constituting a gate electrode is polycrystalline silicon.
